Europäisches Patentamt

European Patent Office

Office européen des brevets

(11) Publication number: **0 427 382 A2**

# EUROPEAN PATENT APPLICATION

(21) Application number: **90309541.2**

(22) Date of filing: **31.08.90**

(51) Int. Cl.⁵: **G03F 7/12, G03F 7/16**

(30) Priority: **07.11.89 GB 8925085**

(43) Date of publication of application:
**15.05.91 Bulletin 91/20**

(84) Designated Contracting States:
**AT BE CH DE DK ES FR GB GR IT LI LU NL SE**

(71) Applicant: **AUTOTYPE INTERNATIONAL LIMITED**
**Grove Road**
**Wantage Oxon OX12 7BZ(GB)**

Applicant: **NOTIO MASKINER A/S**
**Virkelyst 56**

**DK-7400 Herning(DK)**

(72) Inventor: **Stewart, Malcolm John**
**Southfields, Puck Lane**
**Witney, Oxon(GB)**
Inventor: **Dalgaard, Johannes**
**Norretorp 188**
**Gjellerup, DK-7400 Herning(DK)**

(74) Representative: **Ackroyd, Robert et al**
**W.P. THOMPSON & CO. Eastcheap House**
**Central Approach**
**Letchworth, Hertfordshire SG6 3DS(GB)**

(54) **Apparatus for applying a stencil film to a screen printing screen.**

(57) Film 10 from a storage roll mounted within a housing 14 is fed by motorised feed rollers 24 to a screen 30 where it is applied to the screen by a pressure roller 26. The hermetically-sealed housing 14 is demountable from a shelf 18 for changing the type of film without having to remove each film roll from its housing. A flying knife 36 cuts the film after application to the screen. The shelf 18, housing 14, feed rollers 24, pressure roller 26 and knife 36 are driven vertically up the screen by drive means to apply the film to the screen. A counterpressure device 34 is driven in unison to support the screen behind the pressure roller. The counterpressure device may be a coating trough, an indented or embossed roller on a spray bar, according to the type of film to be supplied to the screen.

FIG.2.

## APPARATUS FOR APPLYING A STENCIL FILM TO A SCREEN PRINTING SCREEN

This invention relates to methods and apparatus for applying a stencil film onto a screen-printing screen or plate, prior to use of the screen or plate in a screen printing process.

The screen printing screen or plate, hereinafter referred to simply as a "screen", can be, for example, any of the following:

(1) A woven fabric mesh of polyester, stainless steel, nylon, metal-coated polyester, brass, or other suitable material, stretched and adhered to a rigid frame. The frame is usually rectangular or square in shape and constructed of metal (commonly aluminium or steel), wood, or other rigid material (e.g. ceramic composite or glass/epoxy).

(2) A non-woven plate which has a regular pattern of holes through which an ink or other liquid can be forced and is thereby a suitable alternative to the woven fabric mesh described in (1) above. Examples of these non-woven plate materials include HIMESH (trade mark of Stork Screens BV, the Netherlands) and ALPHA-SCREEN (trade name of Dai Nippon Screen, Japan). Such a non-woven plate can be either fixed permanently to a frame, as described in (1), temporarily supported in frame holder, or held rigidly and vertically by other means.

(3) An etchable plate, usually of a metal such as brass or copper, supported on a rigid frame, or unsupported.

The stencil film can be, for example, any of the following:

(4) A photosensitive emulsion layer or layers accurately pre-coated onto a temporary film support which is normally of polyethylene terephthalate but may be of another film material. Such pre-coated films are well known in the screen printing art, and are known as "capillary photostencil films" or "direct photostencil films". The products include the following:

CAPILLEX (Trade mark of Autotype International Ltd.)

CDF (Trade mark of Ulano Corporation, USA)

PRO-CAP (Trade mark of Chromaline Corporation, USA)

ONE-POT FILM (Trade mark of Murakami Screen, Japan)

After application of the film to the "screen" by the methods described herein and drying of the film, the temporary film support is removed, the photoemulsion layer exposed imagewise to actinic light, developed with water and dried.

(5) A photosensitive emulsion layer or layers, accurately precoated onto a temporary film support, photoimaged and subsequently developed before application to the screen. Such pre-coated films are well known in the screen printing art, and are described as "indirect photostencil films" or simply "indirect films". Examples of indirect films include the following products:

FIVE STAR, NOVASTAR (Trade marks of Autotype International Ltd.)

BLUE POLY 2, SUPER PREP (Trade marks of Ulano Corporation)

(6) A non-photosensitive emulsion or polymer layer which is pre-coated on a temporary support film and is imaged by a "cutting and stripping" operation. In this case, the image is defined by cutting through the emulsion or polymer layer with a knife or sharp implement, guided by hand or under computer control. Subsequently, selected areas of the emulsion or polymer layer are peeled off the temporary support film to produce the final image, ready for application to the printing screen. These pre-coated non-photosensitive films are well known in the screen printing art as "hand-cut stencil films". Examples are the following:

AUTOCUT AMBER, SOLVENT GREEN (Trade marks of Autotype International Ltd)

ULANOCUT AMBA, STA-SHARP GREEN (Trade marks of Ulano Corporation).

The hand-cut stencil films, after cutting and peeling out the image areas, are adhered to a screen using water or a solvent mixture, and dried in situ. The temporary support film is then removed to leave the finished screen stencil.

(7) Any other film product which is intended or suitable for use as a stencil material for the screen printing process, whether imaged before or after being adhered to the screen. The stencil film produced may be imaged by exposure to electromagnetic radiation (commonly UV or visible), by cutting and stripping, or by other process.

(8) A photoresist film, subsequently laminated onto an etchable substrate, such as a brass plate, for producing a stencil for screen printing or stencilling. Such films are used, for example, to produce metal stencils used in the printing of solder creams and pastes in the electronics industry.

Having described the products and applications for which this invention may be used, details of the invention are as follows:

This invention relates to new equipment and a new method of application of stencil films onto screens for screen printing.

Stencil films as mentioned above are well known in the screen printing industry as a way of providing consistent, high quality stencils with minimal operator skill and for a variety of applications.

It is also known that stencils produced from film products have superior printing properties to those made by wet liquid emulsion techniques alone.

However, there are a number of problems which arise in the use of film products, for example:

(1) It is very difficult for an operator to mount large (>1.2 metres wide or long) pieces of stencil film onto a large screen without damaging the film, misregistering, applying the film unevenly or creating pinholes in the stencil.

(2) Dust is a problem in many screen printing shops. It can interfere with stencil preparation, creating pinholes, craters or weak spots in the finished stencil.

(3) Repeated handling of rolls of film by the operator and use of dry screens when mounting the film exacerbate static electrical attraction of dust onto both the film and the mesh fabric.

(4) In the prior art, there are one or two machines which have been developed to overcome these problems in part. However, the machines still require a large amount of handling of the film by the operator, which is time consuming and increases risk of dust contamination.

(5) Existing machines do not produce consistent or satisfactory results when wet screens are used. The use of wet screens has a number of advantages:

- the screen can be reused immediately after cleaning off the last stencil, without the need for drying, allowing faster turnround of screens,
- wet screens are less prone to static attraction of dust,
- wet screens eliminate the need for use of a trough, roller or spray device to apply water or emulsion through the mesh, in order to adhere the stencil film.

According to the present invention, there is provided an apparatus for applying a stencil film to a screen printing screen, the apparatus comprising means for holding a said screen in a generally vertical plane, means for receiving a supply of stencil film to be dispensed for application to a screen held by the holding means, means for feeding stencil film from the film-reception means to the screen, and means for applying pressure to the face of the stencil film which is distant from the screen, in order to bring the film into contact with one face of the screen, wherein the film-reception means, the film-feeding means and the pressure-application means are movable vertically by drive means of the apparatus between first, lower and second, upper limit positions spaced vertically of a screen held by the holding means.

The first and second limit positions are preferably adjacent the lower and upper edges respectively of a screen held by the holding means.

The apparatus can advantageous ly include counterpressure means for supporting the face of the screen opposite to the face into which the film is brought into contact, the counterpressure means being movable by the drive means.

In one embodiment of the invention, the film-reception means comprises means for demountable reception of a housing in which a supply of film can be contained. Advantageously, the housing has an outlet for the film which is sealed against ingress of foreign matter, for example dust.

Advantageously, the film-reception means comprises means for reception of a plurality of supplies of film and the film-feeding means comprises means for selectively feeding film from any one of the supplies to the screen.

Preferably, the apparatus includes means for cutting the film between the film-reception means and the screen. Conveniently, control means control the drive means or mechanism and the film-cutting means so that the film is cut as the pressure-application means approach the second limit position and the entire cut film has been applied to the screen in the second limit position of the pressure-application means.

Other preferred features of the invention can be found in the sub-claims.

According to the invention, there is also provided an apparatus for applying a film, for example a stencil film, to a screen, the apparatus comprising means for mounting the screen, preferably substantially vertically, means for mounting a supply of film, for example a roll, adjacent the screen and mechanical means for feeding film from the supply to the screen and applying the film to the screen.

The mounting means advantageously comprises means which demountably receive a housing containing a supply of film and position the film appropriately relative to the film-feeding means.

The invention also provides a housing for such apparatus, the housing containing a supply of film and having an outlet for the film, the outlet optionally being sealed against ingress of foreign matter, for example dust.

The apparatus preferably includes means for driving the film-mounting means in the direction in which the film is applied to the screen. Such drive means advantageously also return the film-mounting means to its starting position after a pass over the screen.

Advantageously, the apparatus includes a means for supplying liquid to the side of the screen opposite to the film, simultaneously with the application of the film to the screen. Preferably, the liquid-application means is arranged to be driven in unison with the film-application means.

The apparatus preferably includes means for cutting the film applied to the screen from the film supply during the operation of applying the film to the screen.

This invention can thus provide a film housing or cartridge system with carriage mechanism which automatically applies stencil film to either a wet or dry screen, without the need for any manual contact or handling of the film, once the film has been loaded into the housing.

Further, the film housing can be in the form of a film cassette or cartridge provided by the manufacturer of the stencil film, which can be hermetically sealed in the housing under clean room conditions. This housing is mounted onto the film-reception means mentioned above and the operator need handle only the protruding few inches of film when loading the housing onto the apparatus, thereby eliminating problems arising from dust contamination of the film.

An embodiment of the invention is now described by way of example with reference to the drawings, in which:

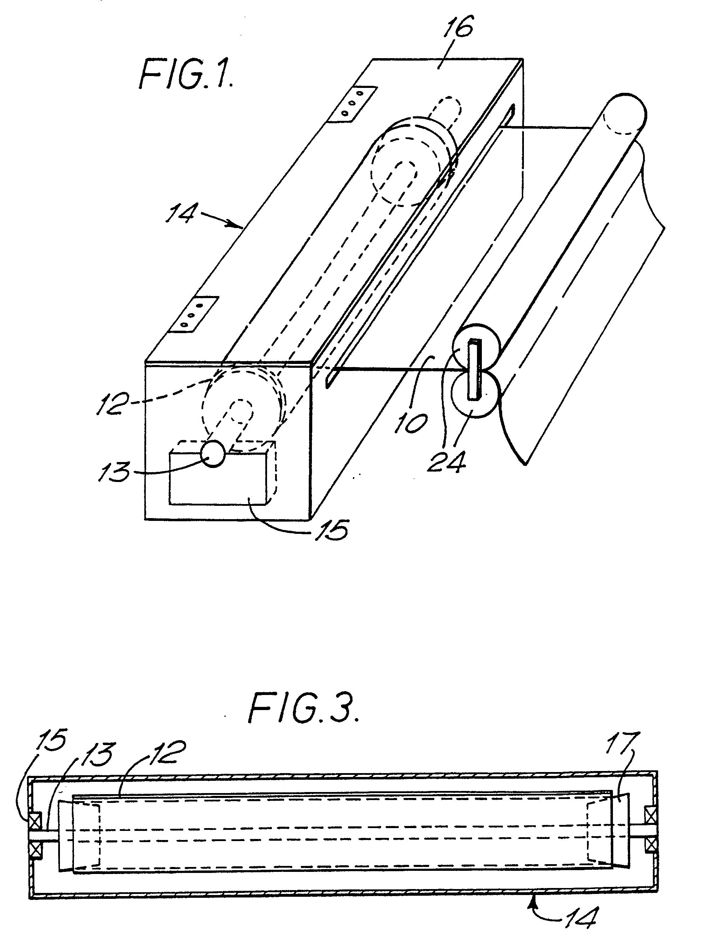

Figure 1 is a perspective view of a film dispenser and feed rollers, which present the film onto a screen.

Figure 2 shows, as an end view partly in section, the application of capillary (or combination) photostencil film, and

Figure 3 is a longitudinal sectional view of the film dispenser of Figure 1.

The drawings show capillary film 10 wound on a plastics core 12 for support, which is held in a film cartridge 14 having a hinged transparent top 16. The transparent top enables the operator to see how much film 10 is left in the cartridge 14. The core 12 is mounted, by way of tapering gripping devices 17, on a shaft or spindle 13 which is rotatable within the housing in roller-bearing journals 15.

The film cartridge 14 is supported on a cartridge shelf 18 and fixed in place on the shelf by means of locating pins 20 on the shelf which are received in sockets 22 in the cartridge.

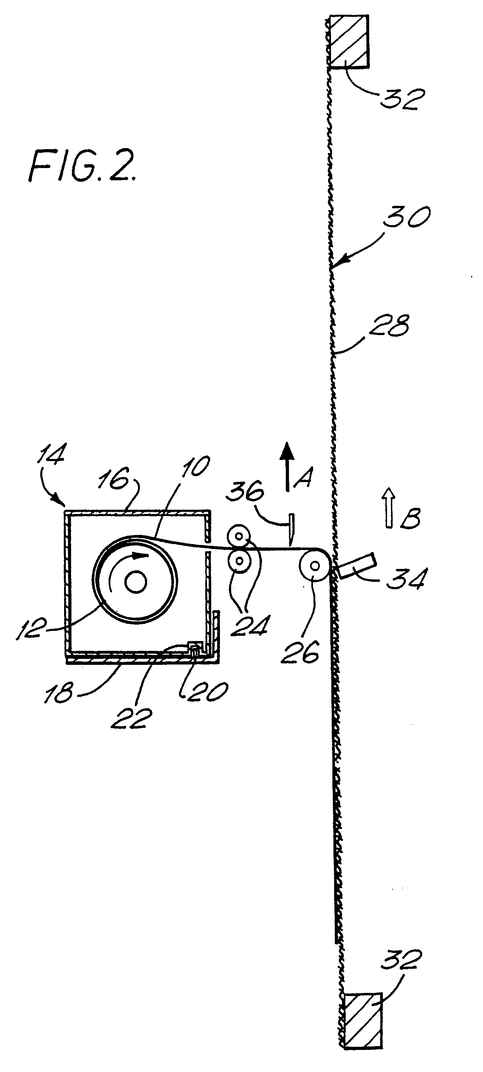

The cartridge shelf 18 can be driven by a drive mechanism to rise vertically in the direction of arrow A on Figure 2. The drive mechanism (not shown) consists of an electric motor and a chain drive which are arranged to raise the cartridge shelf 18 in a pair of vertical guideways in which the shelf is located by suitable runners or rollers at its two ends. Suitable limit switches controlling the motor can define the limits of the travel of the shelf.

The capillary stencil film 10 is fed through a pair of motorised feed rollers 24 to a rubber backing roller 26 which lightly presses the capillary film 10 against the mesh fabric 28 (or non-woven plate) of a screen 30. The feed rollers are driven by a further electric motor (not shown) which is carried by the cartridge shelf 18 and drives the rollers through a toothed belt (not shown) and toothed wheels which are attached to the rollers. The rollers 24 advantageously have free-wheeling devices which allow the film to be drawn through the feed rollers 24 by the backing roller 26 with the drive motor switched off. Thus, it is necessary for the motor to drive the feed rollers 24 only during the initial phase of film feeding before the film becomes attached to the screen 30.

The screen 30 comprises the mesh fabric 28 and a rectangular frame 32 which is mounted vertically in the apparatus and which thus supports the mesh fabric 28 in a vertical plane. At the side of the mesh fabric opposite to the film cartridge 14, the apparatus includes an impressing device 34 which can also be driven to rise vertically (arrow B on Figure 2) by the drive mechanism, in unison with the cartridge shelf 18.

The mesh fabric 28 may be wet or dry. If the mesh fabric is wet, the impressing device 34 is preferably a coating trough which removes and collects surplus water as the film cartridge rises on the movable shelf

However, if the mesh fabric is dry, it is necessary to supply water, solvent, or direct emulsion to enable the capillary stencil film to become adhered to the mesh fabric.

In this case, the impressing device 34 will usually be one of the following:

(1) an emulsion coating trough, as commonly used in the screen printing industry, containing water, solvent or direct emulsion.

(2) An indented or embossed roller which is wetted at a controlled rate by a wetting device.

(3) A fine spray bar, underneath which is a coating trough or rubber squeegee.

The apparatus is used in the following way to mount a stencil film onto the screen.

To load the machines, a roll of stencil film 10 on its plastics core 12 is placed in the film cartridge 14 mounted on the shelf 18 which is in its lowermost, rest position. The leading edge of the film 10 is then fed between the feed rollers 24 and over the top of the backing or pressure roller 26, the film being pressed by the pressure roller onto the fabric 28 of the screen which is held vertically in the apparatus. The machine is now ready for use.

To apply stencil film onto the mesh fabric 28 of the screen 30, the drive mechanism is now started.

As the feed rollers 24 turn, the complete film-mounting assembly comprising the shelf 18, the cartridge 14, the feed rollers 24 and the pressure roller 26, rises in the direction of arrow A and the stencil film 10 is automatically and evenly applied to the screen fabric 28. Upon reaching the top of the screen, the flying knife 36 cuts the film and the feed rollers cease feeding. The complete film-mounting assembly however continue to rise until the free cut end of the film piece is mounted on the screen.

The complete film-mounting assembly comprising the shelf 18, the film cartridge 14 and the feed and pressure rollers 24, 26 then retracts from the screen, as does any impressing device 34 fitted. Both then return to the lowest rest position under control of the drive mechanism.

The screen 30 can then be removed for drying, a new screen inserted manually or automatically and the process may be repeated until the film supply is exhausted, or until the operator wishes to apply a different type or thickness of stencil film. In either case, it is necessary to reload the machine with a fresh cartridge or roll of stencil film.

The complete film-mounting assembly may also include an antistatic device and/or tacky rollers for dust removal from the mesh at a point ahead of that at which the backing roller 26 acts, or an antistatic device or tacky rollers operating between the cartridge 14 and the pressure roller 26. Also the single film dispenser can be replaced by a rotating carousel holding several cartridges of film of different types or thicknesses.

The drive mechanism controlling the movement of the cartridge shelf 18, the feed rollers 24, the backing roller 26, the impressing device 34 and the flying knife 36 can comprise any combination of the usual electrical, mechanical and other types of control elements.

In the above embodiment, the film dispenser is a re-usable unit into which a roll of film is loaded and replaced as necessary.

Alternatively, the film dispenser may comprise a disposable film cartridge in which a roll of film is mounted, the housing optionally being hermetically sealed afterwards, under clean conditions. The housing is then easily fitted in position on the shaft 18, with positionally optionally being aided by use of locator pins or blocks on the shelf 18.

The disposable film cartridge can be simply removed and replaced when required, for example when the contents are exhausted, or alternatively when a different type of stencil film is required for the next screen. With this system, machine down-time is minimised.

Other modifications of the machine may include one or more infra-red, hot air or microwave drier units, which may move up and down the screen attached to the impressing device 34, or linked to a separate drive mechanism.

In a further embodiment of this invention, during or after application of the stencil film onto the screen by the machine, areas of the screen mesh fabric not covered by stencil film may be automatically filled with screen filler or photosensitive direct emulsion by a coating trough linked to the drive mechanism. In its simplest form, this is achieved when the impressing device 34 is a direct emulsion coating trough, filled with photosensitive direct emulsion, and of dimensions very slightly narrower than the internal dimensions of the screen frame 32, but larger than the width of stencil film applied. When the machinery of the invention is used in this mode, there is no need for manual filling of border areas of the screen, otherwise an additional step in the process.

## Claims

1. An apparatus for applying a stencil film to a screen printing screen, the apparatus comprising means for holding a said screen in a generally vertical plane, means for receiving a supply of stencil film to be dispensed for application to a screen held by the holding means, means for feeding stencil film from the film-reception means to the screen, and means for applying pressure to the face of the stencil film which is distant from the screen, in order to bring the film into contact with the screen, wherein the film-reception means, the film-feeding means and the pressure-application means are movable by drive means of the apparatus between first, lower and second, upper limit positions spaced vertically of a screen held by the holding means.

2. An apparatus according to claim 1, in which the first limit position is adjacent the lower edge of a screen held by the holding means.

3. An apparatus according to claim 1 or 2, in which the second limit position is adjacent the upper edge of a screen held by the holding means.

4. An apparatus according to any preceding claim, in which the film-reception means comprises means for demountable reception of a housing in which a supply of film can be mounted.

5. An apparatus according to claim 4, including a housing which has outlet means for the film.

6. An apparatus according to claim 5, in which the outlet means is sealed against ingress of foreign matter whilst allowing film to be fed out.

7. An apparatus according to any preceding claim, in which the film-reception means comprises means for reception of a plurality of supplies of film and the film-feeding means comprises means for selectively feeding film from any one of the supplies to the screen.

8. An apparatus according to any preceding claim, in which the film-reception means comprises means for receiving stencil film in a roll.

9. An apparatus according to any preceding claim, including means for cutting the film between the film-reception means and the screen.

10. An apparatus according to claim 9, including control means controlling the drive means and the film-cutting means so that the film is cut as the pressure-application means approach the second limit position and the entire cut film has been applied to the screen in the second limit position of the pressure-application means.

11. An apparatus according to any preceding claim, including counterpressure means for supporting the face of a screen opposite to the face into which the film is brought into contact, the counterpressure means being movable by the drive means.

12. An apparatus according to claim 11, which the counterpressure means comprises a coating trough.

13. An apparatus according to claim 11, in which the counterpressure means comprises a pressure roller having wetting means for wetting the roller at a controlled rate.

14. An apparatus according to claim 11, in which the counterpressure means comprises a spray bar.

15. An apparatus according to any preceding claim, including means for removal of dust from the screen prior to application of the film.

16. An apparatus according to any preceding claim, including an antistatic device for preventing build-up of a static electrical charge on the film as it is applied to the screen.

17. An apparatus according to any preceding claim, in which the stencil-feeding means comprise a pair of feed rollers, between which the film passes and which are driven by the driven means.

18. An apparatus according to any preceding claim, in which the pressure-application means comprise a pressure roller and resilient biasing means urging the roller towards the screen.

19. An apparatus according to any preceding claim, including means for applying a coating material to the face of a screen opposite to the face into which the film is brought into contact.

20. An apparatus according to any preceding claim, including means for drying a film after its application to a screen held by the holding means, the drying means being moveable by the drive means together with the film-reception, film-feeding and pressure-application means.

21. A housing for demountable reception on the film-reception means of an apparatus according to claim 4, the housing having means for reception inside the housing of a roll of film to be dispensed and outlet means for the film.

22. A housing according to claim 21, in which the outlet means is sealed against ingress of foreign matter whilst allowing the film to be dispensed from the housing.

*FIG.1.*

*FIG.3.*

FIG.2.